# EUROPEAN PATENT SPECIFICATION

(11) **EP 2 592 172 B1**
(45) Date of publication and mention of the grant of the patent: **15.03.2017**
(21) Application number: 11306464.6
(22) Date of filing: 09.11.2011
(51) Int. Cl.: B29D 11/00, C23C 14/24, C23C 16/448

(54) **SUPPORT FOR A LIQUID COMPOSITION**
TRÄGER FÜR EINE FLÜSSIGE ZUSAMMENSETZUNG
SUPPORT POUR UNE COMPOSITION LIQUIDE

(43) Date of publication of application: 15.05.2013
(73) Proprietor: Essilor International (Compagnie Générale d'Optique), 94220 Charenton-le-Pont (FR)
(72) Inventor: Chapet, Francis, 94220 Charent-le-Pont (FR); Conte, Dominique, 94220 Charenton-le-Pont (FR)
(74) Representative: Santarelli

(56) References cited:
- EP-A1- 0 416 759
- WO-A1-03/037613
- US-A- 4 140 735
- US-A1- 2004 031 442

## Description

### FIELD OF THE INVENTION

The invention relates to supports for optical coating liquid compositions to deposit by evaporation treatment on optical articles.

### BACKGROUND ART

It is well known that lenses, and in particular spectacle lenses, comprise an ophthalmic substrate having geometrical features adapted to the wearer.

The ophthalmic substrate requires the addition of coatings, for instance an anti-abrasive coating to increase the abrasion resistance of the lens, an anti-reflective coating to decrease the reflection of light and an anti-soiling coating applied over the anti-reflective coating.

Such coatings are made from liquid compositions which have to be deposited on the ophthalmic substrate.

The method which is often used for depositing an optical coating liquid composition on an optical article is an evaporation treatment. This may be carried out under a vacuum.

During an evaporation treatment, a support comprising a crucible (or a pill) formed by a porous member which is imbibed with a predetermined volume of the optical coating liquid composition is introduced into an evaporation treatment machine and is heated by an evaporation device until the liquid evaporates and thus is deposited on the optical article.

In a variant, the crucible is not formed as a porous member imbibed with the optical coating liquid composition, but rather as a receptacle into which the optical coating liquid composition is poured; and the receptacle is introduced into the evaporation treating machine and is heated by an evaporation device until the liquid evaporates and thus is deposited on the optical article.

Both types of crucible require a user of the evaporation treating machine to grasp the crucible. Thus, it is necessary for the user to wear gloves because optical coating liquid compositions generally comprise solvents which are harmful.

The solvents of the optical coating liquid compositions are generally also volatile. Thus, the user has to be in a ventilated environment.

The invention is directed to a support for an optical coating liquid composition to deposit by evaporation treatment on an optical article, which support is safe to manipulate, simple, compact and economic.

Z r EP 0 416 759 A1 discloses a support comprising a crucible containing a liquid and a frame forming an envelope in which the crucible is wrapped. The frame is configured to partially break at a thinner section connected to the frame to avoid excessive pressure build-up inside the frame.

### SUMMARY OF THE INVENTION

The invention accordingly provides a support for an optical coating liquid composition according to claim 1.

In other words, the support according to the present disclosure is a packaging unit for the optical coating liquid composition, which unit is formed by a cartridge which is easily transportable and storable, easy to handle and safer than the known crucibles mentioned above.

This cartridge can be easily inserted in any treatment process without risk of deterioration of the optical coating liquid composition it comprises.

Indeed, in known processes where pre-treatment steps are needed before the depositing of the optical coating liquid composition comprised in said support, the crucible is generally inserted alone in the treatment chamber of the treating machine, which machine comprises a system to isolate the crucible (in order to protect it) while awaiting the evaporation step of the optical coating liquid composition.

Thanks to the invention, both treatment process and treating machine can be simplified because such isolation systems integrated into the treating machines and accordingly such isolation process steps are eliminated.

According to features preferred as being very simple, convenient and economical for embodying the support according to the invention:
- the frame comprises a break member configured to partially break when said internal pressure of said internal space is greater than said predetermined pressure threshold;
- the frame comprises a conductive member configured to transfer heat to said optical coating liquid composition before and during evaporation treatment;
- said break member has a first thickness and said conductive member has a second thickness and said first thickness is smaller than said second thickness;
- said break member comprises at least one rib configured to weaken said break member;
- the frame comprises a break member and a conductive member which are distinct and joined together;
- said break member and said conductive member are metallic;
- said conductive member has a perimeter which is longer than a perimeter of said break member so that said conductive member is crimped by its perimeter on said perimeter of said break member;
- the support further comprises a baffle member mounted on said frame and comprising at least one opening;
- said baffle member comprises a portion in which are made a plurality of regularly spaced circular openings;
- said baffle member comprises a portion facing to said frame and disposed at a predetermined distance from said frame;
- said baffle member has a perimeter which is longer than a perimeter of said frame so that said baffle member is crimped by its perimeter on said perimeter of said frame;
- said baffle member comprises a roof portion, a lateral portion joined to said roof portion and at least one recess made at least partially in said lateral portion;
- said crucible comprises a porous member which is imbibed with said optical coating liquid composition; and/or
- said crucible comprises a receptacle in which said optical coating liquid composition is poured.

The invention accordingly provides a device comprising a packaging member having at least one receiving element, at least one support as described in present claim 1 introduced into said at least one receiving element and a desiccant filter.

The receiving element has a recess for receiving the support.

The packaging member can comprises a receiving element made of aluminium or made of plastic and a cover element made of aluminium for covering the recess of the receiving element. The packaging device thus forms a blister.

The packaging member can be a box with a cover rather than a blister, box in which a desiccant filter can be introduced.

### BRIEF DESCRIPTION OF THE DRAWINGS

The description of the invention now continues with a detailed description of a preferred embodiment given hereinafter by way of non-limiting example and with reference to the appended drawings. In these drawings:
- Figure 1 is a schematic view of a machine for coating an optical article with an optical coating liquid composition by vacuum evaporation treatment;
- Figures 2 and 3 are partial schematic views of the machine showing a vacuum chamber of the machine with its door respectively open and closed, and a support for the optical coating liquid composition mounted on the door;
- Figure 4 is a perspective view of the support shown in Figures 2 and 3;
- Figure 5 and 6 are, respectively, in section, an assembled perspective view and an exploded perspective view of the support illustrated in Figure 4;
- Figures 7 to 10 show the steps of assembly of the support shown in Figures 4 to 6; and
- Figure 11 to 16 are respectively similar views to Figures 5 to 10, showing a variant of the support.

### DETAILED DESCRIPTION OF PREFERED EMBODIMENTS

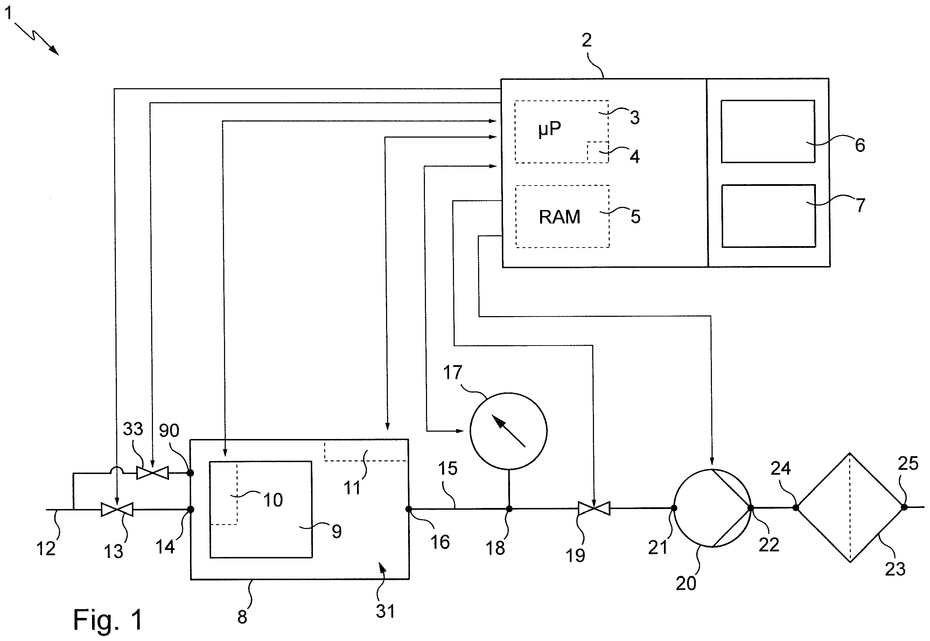

Figure 1 shows a recoat treatment machine 1 for recoating an optical article 28 formed here by spectacle lenses mounted on a spectacle frame.

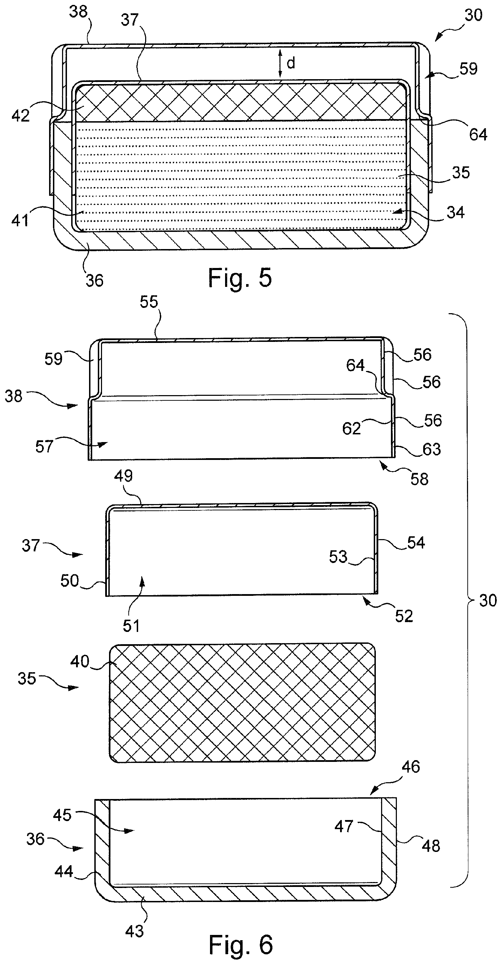

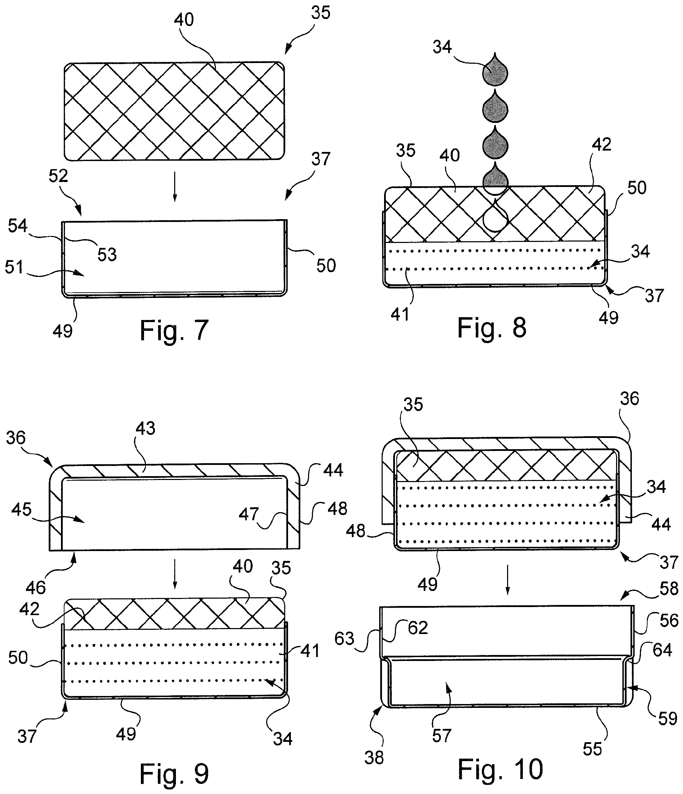

The anti-soiling coating 34 (see Figures 5 and 8) provides an outer coating that can be more resistant to contamination for instance by organic impurities and more easily cleaned than the anti-reflective coating. Thus, the anti-soiling coating protects the anti-reflective coating but may deteriorate over time. The wearer of the lens may therefore wish to replace such an anti-soiling coating. Otherwise, the wearer could buy a classical eyeglass lenses wherein anti-soiling coating is not present, and next would like to obtain such coating.

The machine 1 comprises a vacuum chamber 8, optionally a plasma generator 11, an evaporation device 10, an inlet circuit 12, an outlet circuit 15, a vacuum pump 20 and a control unit 2.

The vacuum chamber 8 comprises an interior space 31 configured to receive the spectacle lenses 28 mounted on a spectacle frame.

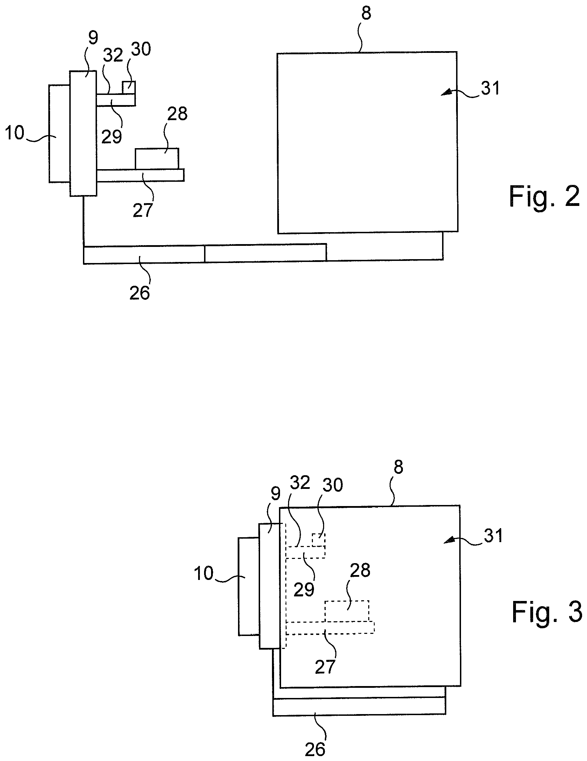

The vacuum chamber 8 further comprises a door 9 which is removable (see description of Figures 2 and 3 below).

The plasma generator 11 is directly connected to the vacuum chamber 8.

The evaporation device 10 is placed in the vacuum chamber 8 (i.e. mounted on the door 9 of the vacuum chamber 8) (see below).

The vacuum chamber 8 further comprises a first inlet port 14 and a second inlet port 90 both connected to the inlet circuit 12.

The machine further comprises a gas inlet valve 13 mounted on said inlet circuit 12 and an inlet valve 33 which is also mounted on said inlet circuit 12, parallel to the inlet valve 13.

The vacuum chamber 8 further comprises an outlet port 16 connected to the outlet circuit 15.

The vacuum pump 20 is connected to the outlet circuit 15 via an admission port 21 of the vacuum pump 20 and via an exit port 22 of said vacuum pump 20 so that the outlet circuit 15 passes through the vacuum pump 20.

The machine 1 further comprises a pressure sensor 17 which is connected to the outlet circuit 15 via a branching point 18.

The machine 1 further comprises a vacuum valve 19 which is mounted on the outlet circuit 15, between the branching point 18 and the admission port 21 of the vacuum pump 20.

The machine 1 further comprises a filtering device 23 here formed by a gas filter.

Said filtering device 23 is connected to the outlet circuit 15 via an entrance port 24 and via an exhaust port 25 of said filtering device 23.

The exhaust port 25 is linked to the atmosphere.

Said filtering device 23 is thus mounted at the end of the outlet circuit 15, after the vacuum pump 20.

The control unit 2 comprises a data processing system comprising a microprocessor 3 having a memory 4, in particular non volatile, allowing a software application, in other words a computer program, to be loaded and stored therein, and which allows the method for recoating the spectacle lenses 28 to be carried out when it is executed in the microprocessor 3.

Said non volatile memory is for instance a read only memory.

The data processing system further comprises a memory 5, for instance volatile, allowing storage of data during the execution of the software and the implementation of the method.

Said volatile memory 5 is for instance a random access memory or an electrically erasable programmable read only memory.

The control unit 2 further comprises a communication interface configured to communicate with the data processing system.

Said communication interface is here formed by a graphical interface 6 and a keyboard 7.

The control unit 2 is configured to control and exchange data with the gas inlet valve 13, the evaporation device 10, the plasma generator 11, the pressure sensor 17, the vacuum valve 19 and the vacuum pump 20.

Figures 2 and 3 show in detail the vacuum chamber 8 and its removable door 9 respectively in an open state and in a closed state.

The vacuum chamber 8 comprises a displacement member 26 configured for sliding the door 9 between its open and closed states.

The machine 1 further comprises a first holder 29 mounted on the interior face of the door 9.

Said first holder 29 is configured to receive a support unit 30 (also named cartridge) filled with a predetermined volume of an anti-soiling coating liquid composition.

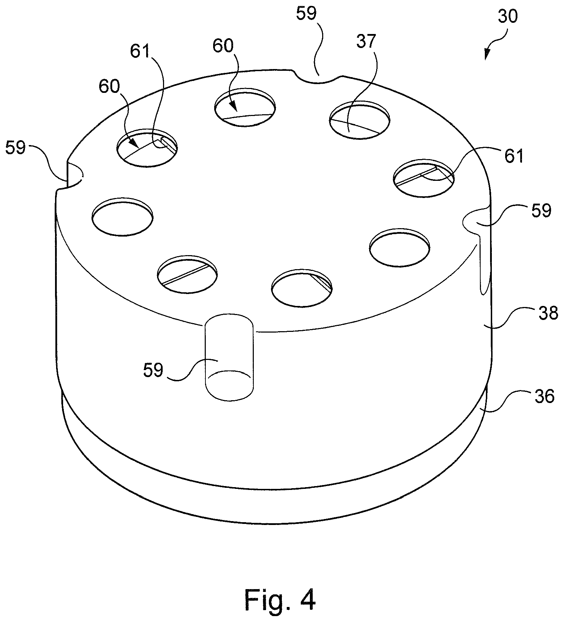

The support unit 30 will be described in detail below with respect to Figures 4 to 10.

The first holder 29 forms part of the evaporation device 10.

The evaporation device 10 is here formed by a heating module 32 mounted on the interior face of the door 9, connected both to the first holder 29 and to a power supply (not shown) in order to heat the anti-soiling coating composition 34 (see Figures 5 and 8) via the support unit 30 and via the first holder 29.

The machine 1 further comprises a second holder 27 also mounted on the interior face of the door 9.

Said second holder 27 is configured to receive the spectacle lenses 28 mounted on the spectacle frame.

The open state of the door 9 makes it possible to load the support unit 30, comprising a crucible 35 at least partially imbibed with the anti-soiling coating composition 34 (see Figures 5 and 8), on the first holder 29 (see description of Figures 4 to 10 below) and the spectacle lenses 28 together with the spectacle frame on the second holder 27.

When the support unit 30 and the spectacle lenses 28 are received on their respective holder 29, 27, the door 9 can be moved from its open state to its closed state as shown in Figure 3.

In this closed state of the door 9, the spectacle lenses 28 together with the spectacle frame and the support unit 30 comprising the anti-soiling coating composition 34 (see Figures 5 and 8) are in the vacuum chamber 8.

Conveniently, the machine 1 is configured to be provided to an optician who can use said machine 1 when the wearer of the spectacle lenses 28 comes into his shop.

The spectacle lenses 28 generally comprise an ophthalmic lens substrate on which are coated, for example, firstly an anti-reflective coating layer and secondly an initial anti-soiling coating layer.

If the effects of the initial anti-soiling layer have deteriorated, the optician can recoat a new anti-soiling layer on the spectacle lenses 28.

The method for using the machine 1 in order to recoat the spectacle lenses 28 with an anti-soiling coating composition 34 (see Figures 5 and 8) which is comprised in the support unit 30 will be described below.

We will now describe in detail the support unit 30 with respect to Figures 4 to 6.

The support 30 comprises a conductive member 36, also named a base, a crucible 35, a break member 37, also named a cover, and a baffle member 38, also named a roof.

The crucible 35 comprises a porous member 40 which is configured to be at least partially imbibed with the anti-soiling coating composition 34.

When the crucible 35 is imbibed with this solution 34, the crucible 35 has a lower part 41, also named first part, which is imbibed with this solution 34 and an upper part 42, also named second part, which is not imbibed.

The porous member 40 has a cylindrical shape, a predetermined diameter and a predetermined height.

The conductive member 36 has a bottom portion 43 which is relatively flat and a tubular lateral portion 44 joined to the bottom portion 43.

The conductive member 36 is made of metal or material which presents high level of heat conductivity, like copper for example.

The conductive member 36 has an internal space 45 which is delimited by the bottom portion 43 and the tubular lateral portion 44.

The conductive member 36 further comprises an opening 46 at the opposite end of the tubular lateral portion 44 to the bottom portion 43.

The bottom portion 43 and tubular lateral portion 44 are each of uniform thickness, but the bottom portion and tubular lateral portion could have different thicknesses.

The tubular lateral portion 44 is of predetermined height.

The tubular lateral portion 44 has an inside perimeter 47 which defines an inside diameter of the conductive member 36 and an outside perimeter 48 which defines an outside diameter of the conductive member 36.

The inside diameter of the conductive member 36 is greater than the diameter of the crucible 35.

The break member 37 comprises a cover portion 49 and a cylindrical lateral portion 50 which is joined to the cover portion 49.

The break member 37 is made of metal, which could be selected, for example from molybdenum or aluminium.

The break member 37 has an internal space 51 which is delimited by the cover portion 49 and the cylindrical lateral portion 50.

The break member 37 further comprises an opening 52 at the opposite end of the cylindrical lateral portion 50 to the cover portion 49.

The cover portion 49 and the cylindrical lateral portion 50 are each of uniform thickness, but they could have different thicknesses.

The cylindrical lateral portion 50 has an inside perimeter 53 which defines an inside diameter of the break member 37 and an outside perimeter 54 which defines an outside diameter of the break member 37.

The inside diameter 53 of the break member 37 is slightly larger than the diameter of the crucible 35 and the outside diameter 54 of the break member 37 is a little smaller than the inside diameter 47 of the conductive member 36.

The cover portion 49 has two longitudinal ribs 61 which extend diagonally on the cover portion 49 and which are perpendicular to each other, which ribs 61 are configured to weaken the cover portion 49 of the break member 37.

Thanks to these ribs 61, the cover portion 49 is configured to break.

The baffle member 38 comprises a roof portion 55 and a cylindrical lateral portion 56 joined to the roof portion 55.

The roof portion 55 and the cylindrical lateral portion 56 are each of uniform thickness which is similar or different to the thickness of the break member 37.

The baffle member 38 is made of plastic material.

The baffle member 38 has an internal space 57 which is delimited by the roof portion 55 and the cylindrical lateral portion 56.

The baffle member 38 has an opening 58 at the opposite end of the cylindrical lateral portion 56 to the roof portion 55.

The baffle member 38 further comprises a plurality of recesses 59, here four recesses 59, in the cylindrical lateral portion 56.

These recesses 59 each extend over about half the height of the cylindrical lateral portion 56, from the junction between the roof portion 55 and the cylindrical lateral portion 56 to about mid-height of the latter.

The baffle member 38 has an inside perimeter 62 which defines a first inside diameter and a second inside diameter (due to the recesses 59) of the baffle member 38 and an outside perimeter 53 which defines a first outside diameter and a second outside diameter (due to the recesses 59) of the baffle member 38.

The first inside diameter is greater than the second inside diameter and the first outside diameter is also greater than the second outside diameter.

The first and second inside diameters of the baffle member 38 are both greater than the outside diameter of the break member 38 (and thus greater than the diameter of the crucible 35).

The first inside diameter of the baffle member 38 is slightly larger than the outside diameter of the conductive member 36 while the second inside diameter and the second outside diameter of the baffle member 38 are smaller than the outside diameter of the conductive member 36, but they are greater than the inside diameter of the conductive member 36.

The recesses 59 in the cylindrical lateral portion 56 provide shoulders 64 in the internal space 57 of the baffle member 38.

These shoulders 64 are formed on the inside perimeter of the baffle member 38, at the junction between the first and second inside diameters.

The baffle member 38 further comprises a plurality of circular openings 60 provided in the roof portion 55.

Here, there are eight openings 60 regularly spaced on the roof portion 55.

Here, the conductive member 36, the break member 37 and the baffle member 38 are all made by stamping.

We will now describe in detail the assembly process of the support unit 30 with respect to Figures 7 to 10.

The crucible 35, in particular the porous member 40, is partially inserted into the internal space 51 of the break member 37.

The inside perimeter 53 of the break member 37 thus comes into contact with the porous member 40.

This porous member 40 is of greater height than the height of the break member 37 so that the porous member 40 is also in contact with the inside surface of the cover portion 49.

The internal space 51 of the break member 37 is thus totally filled by the crucible 35 and the latter protrudes from this internal space 51.

Next, the anti-soiling coating liquid composition 34 is poured on the porous member 40 and the latter is partially imbibed with its solution 34.

Figure 8 shows the liquid solution 34 being poured and Figure 9 shows the porous member 40 imbibed (the coating composition 34 is no longer being poured).

The lower part 41 of the crucible 35 corresponds to the part of the porous member 40 which is imbibed and the upper part 42 of the crucible 35 corresponds to the part of the porous member 40 which is not imbibed.

The height of the lower part 41 is greater than the height of the upper part 42, but the lower part 41 has a height which is less than the height of the cylindrical lateral portion 50 of the break member 37.

The crucible 35 is joined to the break member 37.

For instance, the break member 37 is crimped by its inside perimeter 53 onto the periphery of the porous member 40.

Next, the conductive member 36 is mounted on the first module comprising the break member 37 and the crucible 35 which is imbibed with the liquid composition 34.

The conductive member 36 is mounted on this first module so that the bottom portion 43 is in contact with the upper part 42 of the porous member 40.

In other words, the bottom portion 43 of the conductive member 36 is not (directly) in contact with the cover portion 49 of the break member 37.

A part of the tubular lateral portion 44 of the conductive member 36 covers partially the cylindrical lateral portion 50 of the break member 37.

Thus, the inside perimeter 47 of the tubular lateral portion 44 of the conductive member 36 is in contact with the outside perimeter 54 of the cylindrical lateral portion 50 of the break member 37.

The internal space 45 of the conductive member 36 is almost totally filled with the upper part 42 of the porous member 40, a portion of the lower part 41 of the porous member 40 and a part of the cylindrical lateral portion 50 of the break member 37.

The conductive member 36 is joined to the break member 37.

The conductive member 36 is crimped by its inside perimeter 47 on the outside perimeter 54 of the cylindrical lateral portion 50 of the break member 37.

The first module associated with the conductive member 36 provides a second module.

The conductive member 36 and the break member 37 provide a frame of the support unit 30, this frame forms an envelope for the crucible 35.

This second module is then partially inserted into the internal space 57 of the baffle member 38.

The second module is inserted into this internal space 57 until the free end of the tubular lateral portion 44 of the conductive member 36 comes into contact with the shoulders 64 of the baffle member 38.

The second module is inserted into this internal space 57 so that the cover portion 49 of the break member 37 faces the roof portion 55 of the baffle member 38, but is not in contact with that roof portion 55.

The bottom portion 43 of the conductive member 36 is thus remote from the roof portion 55 of the baffle member 38.

The cover portion 49 of the break member 37 is thus interposed between the roof portion 55 of the baffle member 38 and the bottom portion 43 of the conductive member 36.

More generally, the break member 37 is interposed between the conductive member 36 and the baffle member 38; and the crucible 35 is interposed between the conductive member 36 (with which the crucible 35 is in contact) and the break member 37 (with which the crucible 35 is also in contact) and thus the crucible 35 is interposed between the conductive member 36 and the baffle member 38.

The abutment formed with the shoulder 64 of the baffle member 38 prevents the cover portion 49 from coming into contact with the roof portion 55 and thus maintains a predetermined distance d between that roof portion 55 and cover portion 49. That means the distance d between the roof portion 55 and the cover portion 49 must be enough to let the break member 37 open correctly, so this distance d is preferentially between about 1 mm to about 2mm.

The baffle member 38 is joined to the second module.

The baffle member 38 is crimped by its inside perimeter 62 on the outside perimeter 48 of the conductive member 36.

The predetermined distance d allows for breakage of the break member 37.

In other words, the cover portion 49 having the ribs 61 can be broken and parts of this cover portion 49 can be moved toward the roof portion 55 of the baffle member 38.

The second module associated with the baffle member 38 forms a cartridge 30, also named support unit 30, which is disposable, easily transportable and storable, easy to handle and safer than the known crucibles mentioned above.

The crucible 35 imbibed with the anti-soiling liquid composition 34 is wrapped up and hermetically sealed between the conductive member 36 and the break member 37.

We will now describe in detail the method for using the machine 1 in order to recoat the spectacle lenses 28 with an anti-soiling coating composition 34.

Firstly, the optician takes the spectacle lenses 28 (step of selecting the optical article) and selects the adapted anti-soiling liquid composition 34 to recoat.

The optician opens the door 9 of the vacuum chamber 8 and loads the spectacle lenses 28 and the support unit 30 (or cartridge) on the second holder 27 and on the first holder 29, respectively.

The support unit 30 is disposed on the first holder 29 so that the bottom portion 43 of the conductive member 36 is in contact with the first support 29.

Thus, the support unit 30 is disposed on the first support 29 as shown in Figure 5, conductive member 36 down and baffle member 38 up.

The support unit 30 has previously been filled with a predetermined volume of the new anti-soiling coating composition 34.

The optician does not need to wear gloves to manipulate the support unit 30 because the optician only touches the conductive member and the baffle member element when he grasps the support unit 30.

The optician closes the door 9 of the vacuum chamber 8.

Next, the optician starts the treatment program for recoating the spectacle lenses 28 via the keyboard 7 and the graphical interface 6.

The control unit 2 then takes over the recoating treatment.

The gas inlet valves 13 and 33 are closed.

The vacuum pump 20 is started and the vacuum valve 19 is opened in order to connect (a flow connection) the vacuum pump 20 to the vacuum chamber 8 for evacuating the interior space 31 of the vacuum chamber 8 via the outlet circuit 15. The vacuum pump 20 is thus able to suck the gases from the vacuum chamber 8.

The vacuum valve 19 is opened for a predetermined time, for instance about 20s, until the vacuum chamber pressure reaches a required pressure for evaporation, for instance about 50mbar.

The control unit 2 is configured to control the pressure in the vacuum chamber 8 by taking measurements with the pressure sensor 17.

The vacuum valve 19 is then closed in order to disconnect (a flow interruption) the vacuum pump 20 from the vacuum chamber 8. The vacuum pump 20 is thus not able to suck the gases from the vacuum chamber 8.

The heating module 32 of the evaporation device 11 is then setting for a predetermined time at a predetermined current in order to reach a predetermined temperature of the heating module 32.

The predetermined time is about 30-50s and the predetermined heating temperature is about 350°C. Heat load time and temperature are dependent on evaporation pressure and precursor used.

The heat of the heating module 32 is at least partially transferred to the support unit 30 via the bottom portion 43 of the conductive member 36, which conducts the heat and transfers it to the anti-soiling coating composition 34 which is imbibed in the porous member 40 of the crucible.

The conductive member 36 is here made of a mixture of platinum and bronze.

When the heating module 32 warms up, the heat is transferred to the bottom portion 43 of the conductive member 36, which conducts the heat to the tubular lateral portion 44 of the conductive member 36, and the latter transfers the heat to the porous member 40 and thus the anti-soiling liquid composition 34 is heated and warms up.

The anti-soiling liquid composition 34 warms up until it vaporizes in the internal spaces 51 and 45, respectively of the break member 37 and the conductive member 36.

The heat of the support unit 30 and the vaporization of the anti-soiling liquid composition 34 raise the internal pressure P in these internal spaces 51 and 45.

When the internal pressure P is greater than a predetermined threshold Pth, the cover portion 49 of the break member 37 breaks at the ribs 61.

The cover portion 49 splits into four parts which separate from each other. The parts of the cover portion 49 spread apart in the portion of the internal space 57 of the baffle member 38 which is delimited by the cover portion 49 of the break member 37 and the roof portion 55 of the baffle member 38. In other words, the parts of the cover portion 49 can extend across the predetermined distance d.

Thus, the particles of vapour of the anti-soiling liquid composition 34 escape from the internal spaces 51 and 45, respectively of the break member 37 and the conductive member 36, and more generally from the support unit 30 because these particles of vapour pass through the circular openings 60 provided in roof portion 55 of the baffle member 38.

When the break member 37 breaks due to the internal pressure P, chips of the four parts of the cover portion 49 can be ejected from break member 37, but the roof portion 55 and a part of the cylindrical lateral portion 56 prevent the chips leaving the part of the internal space 45 delimited by the roof portion 55 and the cover portion 49, by forming a barrier.

Next, the heating step is stopped and the evaporation treatment continues for a predetermined time which is for instance 60-180s.

During the evaporation treatment, the anti-soiling coating composition 34 is thus evaporated in the vacuum chamber 8 and the vapour is deposited on the spectacle lenses 28.

Next, the vacuum valve 19 is opened in order to reconnect (a flow connection) the vacuum pump 20 to the vacuum chamber 8 for evacuating said vacuum chamber 8, and in particular for evacuating the gases emitted during the vacuum evaporation treatment because such gases may be toxic. The vacuum pump 20 is thus able to suck the gases from the vacuum chamber 8.

The vacuum valve 19 is then closed so that the vacuum pump 20 is disconnected (a flow interruption) from the vacuum chamber 8. The vacuum pump 20 is thus not able to suck the gases from the vacuum chamber 8.

A venting step is carried out to equalize the chamber pressure with atmospheric pressure.

The gas inlet valve 33 is opened for a predetermined time, for instance 60s, in order to vent the vacuum chamber 8 and the gas inlet valve 13 is then closed.

The optician opens the door 9 of the vacuum chamber 8.

The anti-soiling coating composition 34 has been consumed.

The optician unloads the support unit 30, and also the spectacle lenses 28 which are recoated with a new anti-soiling coating.

There is no further risk for the optician when he unloads the support unit 30 because the baffle member 38 covers the sharp edges of the parts of the cover portion 49 provided by the ribs 61 and also covers the chips of that cover portion 49 of the break member 37.

The support unit 30 is a disposable product and is thus discarded.

Figures 10 to 15 illustrate a variant embodiment of the support unit and are similar views to the Figures 4 to 10.

In general we have used the same reference numbers for similar parts, but increased by 100.

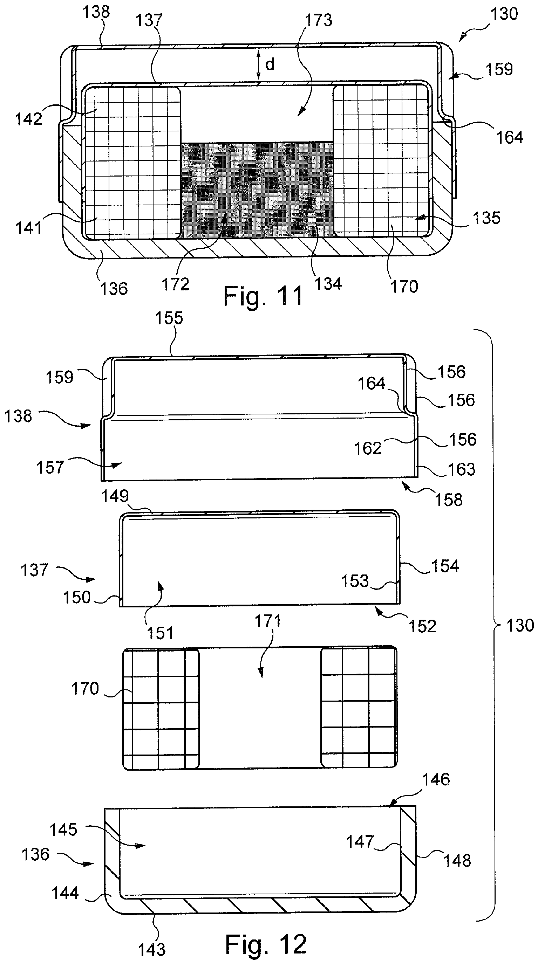

The support unit 130 shown in Figures 11 to 15 is almost identical to the support unit 30 shown in Figures 4 to 10 and the method of assembly of this support unit 130 is also almost identical, except that the crucible 135 of the support unit 130 differs from the crucible 35 of the support unit 30.

The support unit 130 comprises a conductive member 136, a crucible 135, a break member 137, and a baffle member 138.

The crucible 135 (Figures 11, 12, 14 and 15) is here formed by an annular member 170 which is non-porous and by the break member 137 in which the annular member 170 is inserted (see hereafter). This assembly forms the first module, which provides a receptacle in which the anti-soiling coating solution 134 is poured.

The annular member 170 has a predetermined diameter and a predetermined height and an internal space 171.

When the crucible 135 is partially filled with the solution 134, the crucible 135 has a lower part 172, also named first part, which contains solution 134 and an upper part 173, also named second part, which does not contain solution 134.

The conductive member 136 is identical to the conductive member 36.

Thus, the conductive member 136 is made of metal and has a bottom portion 143, a tubular lateral portion 144 joined to the bottom portion 143, an internal space 145 which is delimited by the bottom portion 143 and the tubular lateral portion 144, an opening 146 at the end of the tubular lateral portion 144. The tubular lateral portion 144 has an inside perimeter 147 and an outside perimeter 148 which define respectively an inside diameter and an outside diameter of the conductive member 136; and the inside diameter of the conductive member 136 is greater than the diameter of the annular member 170.

The break member 137 is made of metal and comprises a cover portion 149, a cylindrical lateral portion 150 which is joined to the cover portion 149, an internal space 151 which is delimited by the cover portion 149 and the cylindrical lateral portion 150 and an opening 152 at the end of the cylindrical lateral portion 150. The cylindrical lateral portion 150 has an inside perimeter 153 and an outside perimeter 154 which define respectively an inside diameter and an outside diameter of the break member 137; and the inside diameter 153 of the break member 137 is slightly larger than the diameter of the annular member 170 and the outside diameter 154 of the break member 137 is a little smaller than the inside diameter 147 of the conductive member 136. The cover portion 149 has two longitudinal ribs (not shown) which extend diagonally on the cover portion 149 and which are perpendicular to each other, the ribs being configured to weaken the cover portion 149 of the break member 137.

The baffle member 138 is made of plastic material and comprises a roof portion 155, a cylindrical lateral portion 156 joined to the roof portion 155, an internal space 157 which is delimited by the roof portion 155 and the cylindrical lateral portion 156, an opening 158 at the end of the cylindrical lateral portion 156 and a plurality of recesses 159 in the cylindrical lateral portion 156. The baffle member 138 has an inside perimeter 162 and an outside perimeter 153 which define respectively a first inside diameter and a second inside diameter (due to the recesses 159) and a first outside diameter and a second outside diameter (due to the recesses 59) of the baffle member 138; the first inside diameter is greater than the second inside diameter and the first outside diameter is also greater than the second outside diameter, and the first and second inside diameters of the baffle member 138 are both greater than the outside diameter of the break member 138 (and thus greater than the diameter of the crucible 135); the first inside diameter of the baffle member 138 is slightly larger than the outside diameter of the conductive member 136 while the second inside diameter and the second outside diameter of the baffle member 138 are smaller than the outside diameter of the conductive member 136, but they are greater than the inside diameter of the conductive member 136. The recesses 159 in the cylindrical lateral portion 156 provide shoulders 164 in the internal space 157 of the baffle member 138. The baffle member 138 further comprises a plurality of circular openings (not shown) provided in the roof portion 155.

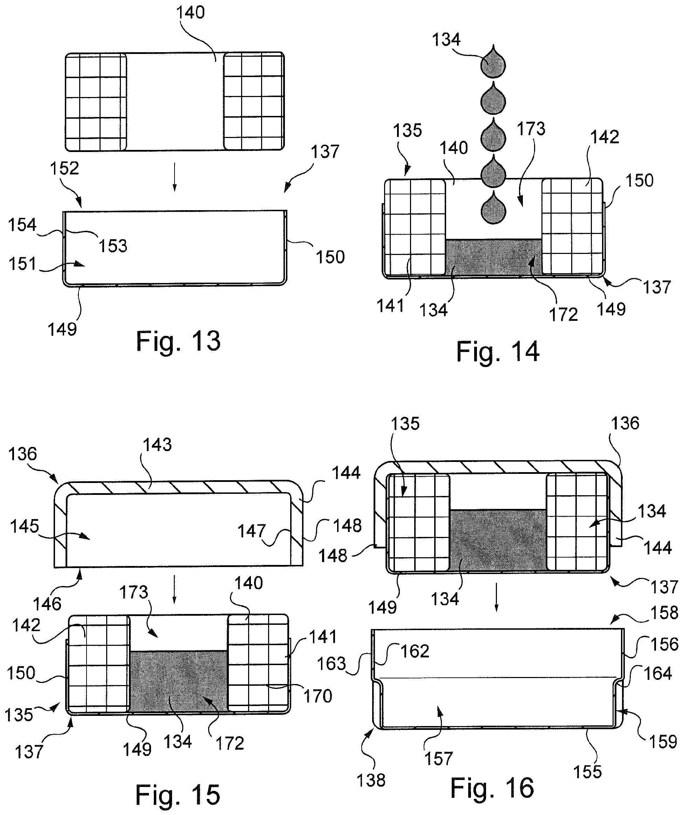

Regarding the assembly process of the support unit 130 with respect to Figures 13 to 16, there is no difference with the assembly of the support unit 30 with respect to Figures 7 to 10, except that the anti-soiling liquid composition 134 is not imbibed by the crucible 135 but directly poured in the lower part 172 of the annular internal space 171, in contact with the inner surface of the annular member 170 and with the inner surface of the cover portion 149 of the break member 137. The cover portion 149 of the break member 137 thus provides a bottom for the crucible 135.

The conductive member 136 and the break member 137 provide a frame of the support unit 130, this frame forming an envelope for the crucible 135.

Regarding now the method for using the machine in order to recoat the spectacle lenses with an anti-soiling coating composition 134, there is no difference with the method described above to recoat the spectacle lenses with an anti-soiling coating composition 34, thus that method will not be described again.

In a variant not illustrated, the support unit is not inserted into a vacuum evaporating machine for recoating an optical article with an anti-soiling coating liquid composition, but rather into a vacuum evaporating machine for depositing a first layer of any coating on an optical article.

For instance, the optical coating liquid composition has anti-reflective properties, or anti-static properties or anti-fogging properties.

In variants that are not illustrated:
- the support unit is devoid of a baffle member element;
- the support unit is not of cylindrical general shape, but rather of rectangular, hexagonal, octagonal or other shape;
- the break member comprises more or less than two ribs on its cover portion; and the ribs have a different shape;
- the baffle member is made of a plastic material which resists to the high temperature and could be coloured to identify different types of coating; or the baffle member is not made of plastic material but rather is made of metal;
- the break member could be made of a multi-metallic layers materials with different coefficients of thermal dilatation. When the break member heats, the tension inside the cover portion increases and the pressure needed to the break is strongly reduced;
- the baffle member comprises more or less than eight circular openings and/or more or less than four recesses;
- the first and second holders are not disposed on the door of the vacuum chamber, but rather directly in the vacuum chamber and the evaporation device, in particular the heating module, is thus not disposed on the door but also in the vacuum chamber; and/or
- the support unit according to the invention can be introduced into a recess of a receiving element of a blister (also named packaging member), which blister also comprises a desiccant filter introduced into the recess of the receiving element and a cover element for covering that recess; or the packaging member can be a box with a cover rather than a blister, box in which a desiccant filter and a support unit can be introduced; or the packaging member can be closed under inert atmosphere.

It should be noted more generally that the invention is not limited to the examples described and represented.

## Claims

1. Support for an optical coating liquid composition to deposit by evaporation treatment on an optical article, comprising a crucible (35; 135) and an optical coating liquid composition (34; 134) which is introduced into said crucible (35; 135); wherein said support (30; 130) further comprises a frame (36, 37; 136, 137) forming an envelope in which said crucible (35; 135) and said optical coating liquid composition (34; 134) are wrapped; said frame (36, 37; 136, 137) having an internal space (45, 51; 145, 151) and being configured to hermetically seal said crucible (35; 135) and said optical coating liquid composition (34; 134) when said internal space (45, 51; 145, 151) has an internal pressure (P) lower than a predetermined pressure threshold (Pth) and being configured to let out vapour of said optical coating liquid composition (34; 134) when said internal pressure (P) of said internal space (45, 51; 145, 151) is greater than said predetermined pressure threshold (Pth); by virtue of which said support (30; 130) constitutes a cartridge of optical coating liquid composition (34; 134), **characterized in that**:
said frame comprises a break member (37; 137) and a conductive member (36; 136) which are each metallic and which are distinct and joined together;
said conductive member (36; 136) has a bottom portion (43; 143), a tubular lateral portion (44; 144) joined to the bottom portion, an internal space (45; 145) which is delimited by the bottom portion and the tubular lateral portion, and an opening (46; 146) which is formed at the opposite of the bottom portion, the tubular lateral portion has an inside perimeter (47; 147) which defines an inside diameter of the conductive member and an outside perimeter (48; 148) which defines an outside diameter of the conductive member and the inside diameter of the conductive member is greater than a diameter of the crucible;
said break member (37; 137) comprises a cover portion (49; 149), a cylindrical lateral portion (50; 150) which is joined to the cover portion, an internal space (51; 151) which is delimited by the cover portion and the cylindrical lateral portion, and an opening (52; 152) which is formed at the opposite of the cover portion, the cylindrical lateral portion has an inside perimeter (53; 153) which defines an inside diameter of the break member and an outside perimeter (54; 154) which defines an outside diameter of the break member, the inside diameter of the break member is larger than the diameter of the crucible and the outside diameter of the break member is smaller than the inside diameter of the conductive member; and
said conductive member (36; 136) is crimped by its inside perimeter (47; 147) on the outer perimeter (54; 154) of the break member(37; 137).

2. Support according to claim 1, wherein the frame comprises a break member (37; 137) configured to partially break when said internal pressure (P) of said internal space (45, 51; 145, 151) is greater than said predetermined pressure threshold (Pth).

3. Support according to any one of claims 1 and 2, wherein the frame comprises a conductive member (36; 136) configured to transfer heat to said optical coating liquid composition (34; 134) before and during evaporation treatment.

4. Support according to claims 2 and 3, wherein said break member (37; 137) has a first thickness and said conductive member (36; 136) has a second thickness and said first thickness is smaller than said second thickness.

5. Support according to any one of claims 2 and 4, wherein said break member (37) comprises at least one rib (61) configured to weaken said break member (37).

6. Support according to any one of claims 1 to 5, wherein it further comprises a baffle member (38; 138) mounted on said frame (36, 37; 136, 137) and comprising at least one opening (60; 160).

7. Support according to claim 6, wherein said baffle member (38; 138) comprises a portion (55; 155) in which are made a plurality of regularly spaced circular openings (60; 160).

8. Support according to any one of claims 6 and 7, wherein said baffle member (38; 138) comprises a portion (55; 155) facing to said frame (36, 37; 136, 137) and disposed at a predetermined distance (d) from said frame (36, 37; 136, 137).

9. Support according to any one of claims 6 to 8, wherein said baffle member (38; 138) has a perimeter (62; 162) which is longer than a perimeter of said frame (36, 37; 136, 137) so that said baffle member (38; 138) is crimped by its perimeter (62; 162) on said perimeter of said frame (36, 37; 136, 137).

10. Support according to any one of claims 6 to 9, wherein said baffle member (38; 138) comprises a roof portion (55; 155), a lateral portion (56; 156) joined to said roof portion (55; 155) and at least one recess (59; 159) made at least partially in said lateral portion (56; 156).

11. Support according to any one of claims 1 to 10, wherein said crucible (35) comprises a porous member (40) which is imbibed with said optical coating liquid composition (34).

12. Support according to any one of claims 1 to 10, wherein said crucible (135) comprises a receptacle (137, 170) in which said optical coating liquid composition (134) is poured.

13. Device comprising a packaging member having at least one receiving element, at least one support (30; 130) according to any one of claims 1 to 12 introduced into said at least one receiving element and a desiccant filter.

## Patentansprüche

1. Träger für eine optische Beschichtungsflüssigkeitszusammensetzung zum Ablagern durch eine Verdampfungsbehandlung auf einem optischen Gegenstand, umfassend einen Tiegel (35; 135) und eine optische Beschichtungsflüssigkeitszusammensetzung (34; 134), die in den Tiegel (35; 135) eingeführt wird; wobei der Träger (30; 130) ferner einen Rahmen (36, 37; 136, 137) aufweist, der eine Hülle bildet, in welcher der Tiegel (35; 135) und die optische Beschichtungsflüssigkeitszusammensetzung (34; 134) umhüllt sind; wobei der Rahmen (36, 37; 136, 137) einen Innenraum (45, 51; 145, 151) aufweist und konfiguriert ist, um den Tiegel (35; 135) und die optische Beschichtungsflüssigkeitszusammensetzung (34; 134) hermetisch zu versiegeln, wenn der Innenraum (45, 51; 145, 151) einen Innendruck (P) aufweist, der niedriger ist als ein im Voraus festgelegter Druckschwellenwert (Pth), und konfiguriert ist, um Dampf der optischen Beschichtungsflüssigkeitszusammensetzung (34; 134) herauszulassen, wenn der Innendruck (P) des Innenraumes (45, 51; 145, 151) größer ist als der im Voraus festgelegte Druckschwellenwert (Pth); wodurch der Träger (30; 130) eine Kartusche einer optischen Beschichtungsflüssigkeitszusammensetzung (34; 134) darstellt, **dadurch gekennzeichnet, dass**:
der Rahmen ein Bruchelement (37; 137) und ein Leitungselement (36; 136) aufweist, die jeweils metallisch sind und die gesondert und miteinander verbunden sind;
das Leitungselement (36; 136) einen unteren Abschnitt (43; 143), einen rohrartigen lateralen Abschnitt (44; 144), der mit dem unteren Abschnitt verbunden ist, einen Innenraum (45; 145), der von dem unteren Abschnitt und dem rohrartigen lateralen Abschnitt begrenzt ist, und eine Öffnung (46; 146) aufweist, die gegenüber dem unteren Abschnitt geformt ist, wobei der rohrartige laterale Abschnitt einen inneren Umfang (47; 147) aufweist, der einen Innendurchmesser des Leitungselements definiert, und einen äußeren Umfang (48; 148) aufweist, der einen Außendurchmesser des Leitungselements definiert, und der Innendurchmesser des Leitungselements größer ist als ein Durchmesser des Tiegels;
das Bruchelement (37; 137) einen Abdeckungsabschnitt (49; 149), einen zylindrischen lateralen Abschnitt (50; 150), der mit dem Abdeckungsabschnitt verbunden ist, einen Innenraum (51; 151), der von dem Abdeckungsabschnitt und dem zylindrischen lateralen Abschnitt begrenzt ist, und eine Öffnung (52; 152) aufweist, die gegenüber dem Abdeckungsabschnitt geformt ist, wobei der zylindrische laterale Abschnitt einen inneren Umfang (53; 153) aufweist, der einen Innendurchmesser des Bruchelements definiert, und einen äußeren Umfang (54; 154) aufweist, der einen Außendurchmesser des Bruchelements definiert, der Innendurchmesser des Bruchelements größer ist als der Durchmesser des Tiegels und der Außendurchmesser des Bruchelements kleiner ist als der Innendurchmesser des Leitungselements; und
das Leitungselement (36; 136) durch seinen inneren Umfang (47; 147) auf den äußeren Umfang (54; 154) des Bruchelements (37; 137) gecrimpt ist.

2. Träger nach Anspruch 1, wobei der Rahmen ein Bruchelement (37; 137) aufweist, das konfiguriert ist, um teilweise zu brechen, wenn der Innendruck (P) des Innenraumes (45, 51; 145, 151) größer ist als der im Voraus festgelegte Druckschwellenwert (Pth).

3. Träger nach einem der Ansprüche 1 und 2, wobei der Rahmen ein Leitungselement (36; 136) aufweist, das konfiguriert ist, um vor und während der Verdampfungsbehandlung Wärme zu der optischen Beschichtungsflüssigkeitszusammensetzung (34; 134) zu übertragen.

4. Träger nach Anspruch 2 und 3, wobei das Bruchelement (37; 137) eine erste Stärke aufweist und das Leitungselement (36; 136) eine zweite Stärke aufweist und die erste Stärke kleiner ist als die zweite Stärke.

5. Träger nach einem der Ansprüche 2 und 4, wobei das Bruchelement (37) mindestens eine Lamelle (61) aufweist, die konfiguriert ist, um das Bruchelement (37) zu schwächen.

6. Träger nach einem der Ansprüche 1 bis 5, wobei er ferner ein Dampfsperrenelement (38; 138) aufweist, das an dem Rahmen (36, 37; 136, 137) montiert ist und mindestens eine Öffnung (60; 160) aufweist.

7. Träger nach Anspruch 6, wobei das Dampfsperrenelement (38; 138) einen Abschnitt (55; 155) aufweist, in dem mehrere regelmäßig beabstandete zirkuläre Öffnungen (60; 160) angeordnet sind.

8. Träger nach einem der Ansprüche 6 und 7, wobei das Dampfsperrenelement (38; 138) einen Abschnitt (55; 155) aufweist, der zu dem Rahmen (36, 37; 136, 137) zeigt und in einem im Voraus festgelegten Abstand (d) von dem Rahmen (36, 37; 136, 137) angeordnet ist.

9. Träger nach einem der Ansprüche 6 bis 8, wobei das Dampfsperrenelement (38; 138) einen Umfang (62; 162) aufweist, der länger ist als ein Umfang des Rahmens (36, 37; 136, 137), derart, dass das Dampfsperrenelement (38; 138) durch seinen Umfang (62; 162) auf den Umfang des Rahmens (36, 37; 136, 137) gecrimpt ist.

10. Träger nach einem der Ansprüche 6 bis 9, wobei das Dampfsperrenelement (38; 138) einen Dachabschnitt (55; 155), einen lateralen Abschnitt (56; 156), der mit dem Dachabschnitt (55; 155) verbunden ist, und mindestens eine Vertiefung (59; 159) aufweist, die zumindest teilweise in dem lateralen Abschnitt (56; 156) angeordnet ist.

11. Träger nach einem der Ansprüche 1 bis 10, wobei der Tiegel (35) ein poröses Element (40) aufweist, das die optische Beschichtungsflüssigkeitszusammensetzung (34) aufgesogen hat.

12. Träger nach einem der Ansprüche 1 bis 10, wobei der Tiegel (135) ein Aufnahmeelement (137, 170) aufweist, in welches die optische Beschichtungsflüssigkeitszusammensetzung (134) gegossen wird.

13. Vorrichtung, umfassend ein Verpackungselement, das mindestens ein aufnehmendes Element, wobei mindestens ein Träger (30; 130) nach einem der Ansprüche 1 bis 12 in das mindestens eine aufnehmende Element eingeführt ist, und einen Trockenmittelfilter aufweist.

## Revendications

1. Support pour une composition liquide de revêtement optique destinée à être déposée par traitement par évaporation sur un article optique, comprenant un creuset (35 ; 135) et une composition liquide de revêtement optique (34 ; 134) qui est introduite dans ledit creuset (35 ; 135) ; ledit support (30 ; 130) comprenant en outre un cadre (36, 37 ; 136, 137) formant une enveloppe dans laquelle ledit creuset (35 ; 135) et ladite composition liquide de revêtement optique (34 ; 134) sont enfermés ; ledit cadre (36, 37 ; 136, 137) ayant un espace interne (45, 51 ; 145, 151) et étant configuré pour sceller hermétiquement ledit creuset (35, 135) et ladite composition liquide de revêtement optique (34 ; 134) lorsque ledit espace interne (45, 51 ; 145, 151) est à une pression interne (P) inférieure à un seuil de pression prédéterminé (Pₜₕ) et étant configuré pour laisser s'échapper de la vapeur de ladite composition liquide de revêtement optique (34 ; 134) lorsque ladite pression interne (P) dudit espace interne (45, 51 ; 145, 151) est supérieure audit seuil de pression prédéterminé (Pₜₕ) ; grâce à quoi ledit support (30 ; 130) constitue une cartouche de composition liquide de revêtement optique (34 ; 134), **caractérisé en ce que** :
ledit cadre comprend un organe de rupture (37 ; 137) et un organe conducteur (36 ; 136) qui sont chacun métalliques et qui sont distincts l'un de l'autre et réunis l'un à l'autre ;
ledit organe conducteur (36 ; 136) présente une portion inférieure (43 ; 143), une portion latérale tubulaire (44 ; 144) réunie à la portion inférieure, un espace interne (45 ; 145) qui est délimité par la portion inférieure et la portion latérale tubulaire, et une ouverture (46 ; 146) qui est formée à l'opposé de la portion inférieure, la portion latérale tubulaire présentant un périmètre intérieur (47 ; 147) qui définit un diamètre intérieur de l'organe conducteur et un périmètre extérieur (48 ; 148) qui définit un diamètre extérieur de l'organe conducteur et le diamètre intérieur de l'organe conducteur étant supérieur à un diamètre du creuset ;
ledit organe de rupture (37 ; 137) comprend une portion de recouvrement (49 ; 149), une portion latérale cylindrique (50 ; 150) qui est réunie à la portion de recouvrement, un espace interne (51 ; 151) qui est délimité par la portion de recouvrement et la portion latérale cylindrique, et une ouverture (52 ; 152) qui est formée à l'opposé de la portion de recouvrement, la portion latérale cylindrique présentant un périmètre intérieur (53 ; 153) qui définit un diamètre intérieur de l'organe de rupture et un périmètre extérieur (54 ; 154) qui définit un diamètre extérieur de l'organe de rupture, le diamètre intérieur de l'organe de rupture étant supérieur au diamètre du creuset et le diamètre extérieur de l'organe de rupture étant inférieur au diamètre intérieur de l'organe conducteur ; et
ledit organe conducteur (36 ; 136) est serti par son périmètre intérieur (47 ; 147) sur le périmètre extérieur (54 ; 154) de l'organe de rupture (37 ; 137).

2. Support selon la revendication 1, dans lequel le cadre comprend un organe de rupture (37 ; 137) configuré pour se rompre en partie lorsque ladite pression interne (P) dudit espace interne (45, 51 ; 145, 151) est supérieure audit seuil de pression prédéterminé (Pₜₕ).

3. Support selon l'une quelconque des revendications 1 et 2, dans lequel le cadre comprend un organe conducteur (36 ; 136) configuré pour transférer la chaleur à ladite composition liquide de revêtement optique (34 ; 134) avant et pendant le traitement par évaporation.

4. Support selon les revendications 2 et 3, dans lequel ledit organe de rupture (37 ; 137) présente une première épaisseur et ledit organe conducteur (36 ; 136) présente une deuxième épaisseur et ladite première épaisseur est inférieure à ladite deuxième épaisseur.

5. Support selon l'une quelconque des revendications 2 et 4, dans lequel ledit organe de rupture (37) comprend au moins une nervure (61) configurée pour affaiblir ledit organe de rupture (37).

6. Support selon l'une quelconque des revendications 1 à 5, comprenant en outre un organe de chicane (38 ; 138) monté sur ledit cadre (36, 37 ; 136, 137) et comprenant au moins une ouverture (60 ; 160) .

7. Support selon la revendication 6, dans lequel ledit organe de chicane (38 ; 138) comprend une portion (55 ; 155) dans laquelle sont réalisées une pluralité d'ouvertures circulaires espacées régulièrement (60 ; 160).

8. Support selon l'une quelconque des revendications 6 et 7, dans lequel ledit organe de chicane (38 ; 138) comprend une portion (55 ; 155) en regard dudit cadre (36, 37 ; 136, 137) et disposée à une distance prédéterminée (d) dudit cadre (36, 37 ; 136, 137).

9. Support selon l'une quelconque des revendications 6 à 8, dans lequel ledit organe de chicane (38 ; 138) présente un périmètre (62 ; 162) qui est plus long qu'un périmètre dudit cadre (36, 37 ; 136, 137) de telle sorte que ledit organe de chicane (38 ; 138) soit serti par son périmètre (62 ; 162) sur ledit périmètre dudit cadre (36, 37 ; 136, 137) .

10. Support selon l'une quelconque des revendications 6 à 9, dans lequel ledit organe de chicane (38 ; 138) comprend une portion de toit (55 ; 155), une portion latérale (56 ; 156) réunie à ladite portion de toit (55 ; 155) et au moins un retrait (59 ; 159) réalisé au moins en partie dans ladite portion latérale (56 ; 156).

11. Support selon l'une quelconque des revendications 1 à 10, dans lequel ledit creuset (35) comprend un organe poreux (40) qui est imbibé avec ladite composition liquide de revêtement optique (34).

12. Support selon l'une quelconque des revendications 1 à 10, dans lequel ledit creuset (135) comprend un réceptacle (137, 170) dans lequel est versée ladite composition liquide de revêtement optique (134) .

13. Dispositif comprenant un organe d'emballage ayant au moins un élément de réception, au moins un support (30 ; 130) selon l'une quelconque des revendications 1 à 12 introduit dans ledit au moins un élément de réception et un filtre dessiccatif.
